Europäisches Patentamt

European Patent Office

Office européen des brevets

(11) Veröffentlichungsnummer : **0 119 157**
B1

# (12) EUROPÄISCHE PATENTSCHRIFT

(45) Veröffentlichungstag der Patentschrift :
19.08.87

(21) Anmeldenummer : 84730018.3

(22) Anmeldetag : 08.03.84

(51) Int. Cl.⁴ : **H 05 K  3/34**, B 23 K  1/08

(54) **Verfahren zum Löten plattenförmiger Schaltungsträger innerhalb einer Schutzgasiöteinrichtung.**

(30) Priorität : 15.03.83 DE 3309648

(43) Veröffentlichungstag der Anmeldung :
19.09.84 Patentblatt 84/38

(45) Bekanntmachung des Hinweises auf die Patenterteilung : 19.08.87 Patentblatt 87/34

(84) Benannte Vertragsstaaten :
DE FR GB

(56) Entgegenhaltungen :
CH-A-  308 045
FR-A- 1 409 403
FR-A- 1 416 395
GB-A- 2 009 012
IBM TECHNICAL DISCLOSURE BULLETIN, Band 11,
Nr. 12, Mai 1969, Seite 1687, New York, USA J.J.
MELE: "Oxidation prevention"

(73) Patentinhaber : Siemens Aktiengesellschaft Berlin
und München
Wittelsbacherplatz 2
D-8000 München 2 (DE)

(72) Erfinder : Christoph, Heinz, Dipl.-Ing.
Wiesenstrasse 8
D-8501 Erkental (DE)
Erfinder : Gamalski, Jürgen, Dipl.-Ing.
Jägerstrasse 9
D-1000 Berlin 20 (DE)
Erfinder : Lenz, Eduard, Dipl.-Ing.
Im Heidewinkel 10d
D-1000 Berlin 13 (DE)
Erfinder : Neumann, Ulrich
Ostburger Weg 79d
D-1000 Berlin 47 (DE)
Erfinder : von der Schmidt, Reinhard
Harzer Strasse 12
D-1000 Berlin 44 (DE)

**Beschreibung**

Die Erfindung betrifft ein Verfahren zum Löten plattenformiger Schaltungsträger innerhalb einer Schutzgaslöteinrichtung, in deren beheizbarem und gegenüber der Umgebung gasdichten Reaktionsraum zumindest ein Lötbad und zumindest eine in Durchlaufrichtung der Schaltungsträger vor dem Lötbad gelegene Düse zum Einleiten des Schutzgases angeordnet sind.

Ein derartiges flußmittelfreies Lötverfahren ist bereits beim Aufbau von Dickschichtschaltungen angewendet worden und hat sich gegenüber dem konventionellen Löten in Luftatmosphäre und mit Flußmittel als vorteilhaft erwiesen. Eine Fülle von Lötfehlern, wie z. B. Lötbrücken, Lötzapfen und Lunker, deren Auftreten ausschließlich oder zumindest unter anderem auf den Einfluß der verwendeten Flußmittel zurückzuführen ist, können mit einem derartigen Löten unter Schutzgas vermieden werden. Für die Durchführung des bekannten Schutzgaslötverfahrens wird z. B. eine rundum gekapselte Schwallbad-Löteinrichtung verwendet, die einen gegenüber der Umgebung gasdichten Reaktionsraum bildet. Durch Zuführen eines sauerstofffreien Schutzgases (Formiergas) wird in dem Reaktionsraum eine Atmosphäre hergestellt, in der der eigentliche Lötvorgang ohne Einwirkung eines Flußmittels durchgeführt werden kann. Es hat sich dabei als notwendig, zumindest aber als zweckmäßig, erwiesen, die Schaltungsträger vor bzw. während ihres Transports zum eigentlichen Schwallbad zu erwärmen. Dies geschieht beispielsweise derart, daß das eigentliche Schwallbad im mittleren Bereich eines gekapselten Durchlaufkanals angeordnet wird, der einen an die Abmessungen der zu lötenden Schaltungsträger angepaßten flachen Querschnitt aufweist, im Bereich vor dem Schwallbad sind im Durchlaufkanal Heizkörper angeordnet, die die Schaltungsträger auf die gewünschte Temperatur erhitzen. Durch mehrere Düsen sowohl vor als auch nach dem Schwallbad wird das Formiergas in den Durchlaufkanal eingeblasen ; das Schutzgas baut innerhalb des Durchlaufkanals einen geringen Überdruck auf und strömt am Kanaleingang und -ausgang wieder aus, wodurch ein Eindringen der Umgebungsluft in das Innere des Durchlaufkanals verhindert wird.

Bisher bekanntgewordene Versuche zur Übertragung des bekannten Verfahrens auf das Löten von konventionellen Leiterplatten, bei denen die Leiterbahnen auf der einen Fläche und die Bauelemente auf der anderen Fläche der Leiterplatte angeordnet sind, sind bisher erfolglos geblieben. Die Erfindung zeigt nun einen Weg, wie das bekannte Verfahren auch für derartige Leiterplatten eingesetzt werden kann. Dies geschieht erfindungsgemäß derart, daß des Schutzgas auf eine zumindest geringfügig höher als die gewünschte Temperatur der Lötseite der Schaltungsträger bei deren Ankunft am Lötbad bemessene Temperatur vorgeheizt ist und die Düse(n) derart angeordnet ist (sind), daß lediglich die Lötseite der Schaltungsträger direkt angeströmt wird.

Der wesentliche Vorteil des erfindungsgemäßen Verfahrens besteht darin, daß verhältnismäßig hohe Temperaturen auf der Lötseite der Schaltungsträger und damit verbunden eine ausgeprägte Reduzierwirkung des Schutzgases in diesem Bereich erzielt werden können, ohne dabei die auf der anderen Seite des Schaltungsträgers angeordneten Bauelemente einer erhöhten oder gar unzulässigen Temperaturbelastung auszusetzen. Damit kann die Vorheizung der Schaltungsträger im Eingangsbereich des Reaktionsraums vermindert werden bzw. kann gänzlich auf eine derartige Vorheizung verzichtet und als einzige Wärmequelle das Schutzgas benutzt werden.

Das Vorhandensein bzw. Nichtvorhandensein einer Heizstrecke im Reaktionsraum ist nur einer der Parameter für die Einstellung der Schutzgastemperatur. Weitere Parameter sind die Menge des zugeführten Schutzgases und die Verweilzeit der Schaltungsträger vor den Düsen. In diesem Zusammenhang sieht eine vorteilhafte Weiterbildung der Erfindung vor, daß die Vorheizung des Schutzgases derart gesteuert ist, daß das Schutzgas mit einer mehr als das Doppelte der gewünschten Temperatur der Lötseite der Schaltungsträger bei deren Ankunft am Lötbad betragenden Temperatur auf die Lötseite auftrifft und daß die Zufuhr des Schutzgases und/oder das Verweilen der Schaltungsträger vor der (den) Düse(n) kurzzeitig erfolgt. Es wird also die kurzzeitige Beeinflussung der Lötseite mit einem Schutzgas entsprechend höherer Temperatur einem Verfahren vorgezogen, bei dem eine längere Verweilzeit der Lötseite bei entsprechend geringerer Temperatur des Schutzgases vorliegt. Damit sind geringere Beeinflussungen der Rückseite des Schaltungsträgers bzw. der auf diesem angeordneten Bauelemente zu erzielen. Die Temperatur des Schutzgases wird beispielsweise auf mehr als 600 °C gesteigert. Bei diesen Temperaturen findet innerhalb einer in Sekunden bemessenen Zeitspanne eine nahezu völlige Reduktion von Oxyden an der Lötseite der Leiterplatten statt.

Weitere vorteilhafte Ausgestaltung der Erfindung dienen dem Zweck, bestimmte Temperaturverteilungen auf der Lötseite der Schaltungsträger zu erzielen. Beispielsweise ist in diesem Zusammenhang vorgesehen, daß die Schaltungsträger über derart angeordnete Düsen angeströmt werden, daß sich eine annähernd gleichmäßige Temperaturverteilung auf der Lötseite der Schaltungsträger einstellt. Dies kann dadurch gefördert werden, daß Düsen mit schlitzförmigen Austrittsöffnungen verwendet werden.

Die Temperaturverteilung auf der Lötseite der Schaltungsträger kann dadurch optimiert werden, daß Düsen mit schlitzförmigen Austrittsöffnungen verwendet werden. Bei ungedrosselter Anschaltung sämtlicher Düsen an die Gasversorgung kann die gesamte Lötseite eines Schaltungsträgers maximaler Abmessungen auf eine annähernd gleiche Temperatur gebracht werden. Ebenso ist es durch entsprechende Einstellung — durch eine frei programmierbare Programmsteuereinrichtung realisierbar — möglich, bestimmte Bereiche der Leiterplatte, in denen keine Lötstellen auftreten bzw. an deren Rückseite besonders empfindliche Bauelemente angeordnet sind, auf etwas niedrigere Temperaturen aufzuheizen.

Die Erfindung wird im folgenden anhand eines schematisch dargestellten Ausführungsbeispiels erläutert.

Innerhalb eines Lötkanals 1 befindet sich ein Schwall-Lötbad 2, dem mittels einer Fördervorrichtung 3 Leiterplatten 4 zugeführt werden. Bevor die mittels Arretierungselementen 5 an der Fördervorrichtung 3 befestigten Leiterplatten 4 das Schwall-Lötbad 2 erreichen, passieren sie mehrere senkrecht zur Förderrichtung nebeneinander angeordnete schlitzförmige Düsen 6. Die Düsen 6 sind über steuerbare Ventile 7 an eine Gasversorgungsquelle 8 angeschlossen, die ein reduzierendes Gas beinhaltet.

Die Temperatur des Gases ist derart gewählt, daß die den Düsen 6 zugewandte Lötseite der Leiterplatten 4 auf eine deutlich höher als die Löttemperatur bemessene Temperatur aufgeheizt wird.

Am Ort des Ein- und Austritts der Fördervorrichtung 3 in den Lötkanal 1 wird anströmendes Gas abgeführt. Die über die Ventile 7 in den Lötkanal 1 eingeführte Gasmenge muß derart bemessen werden, daß innerhalb des Lötkanals 1 ein ständiger geringfügiger Überdruck gegenüber der Außenatmosphäre herrscht ; damit ist ein Eindringen von Umgebungsluft in das Innere des Lötkanals 1 verhindert.

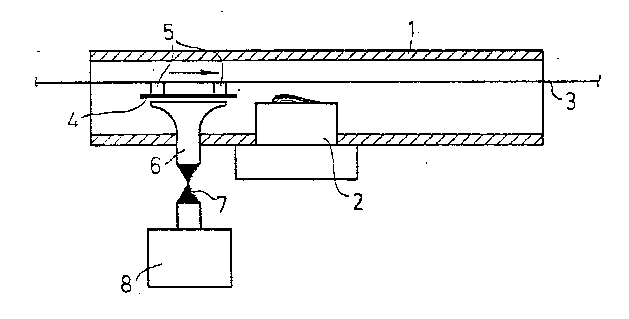

## Patentansprüche

1. Verfahren zum Löten plattenförmiger Schaltungsträger (4) innerhalb einer Schutzgaslöteinrichtung, in deren beheizbarem und gegenüber der Umgebung gasdichtem Reaktionsraum zumindest ein Lötbad (2) und zumindest eine in Durchlaufrichtung der Schaltungsträger (4) vor dem Lötbad (2) gelegene Düse (6) zum Einleiten des Schutzgases angeordnet sind, dadurch gekennzeichnet, daß das Schutzgas auf eine zumindest geringfügig höher als die gewünschte Temperatur der Lötseite der Schaltungsträger (4) bei deren Ankunft am Lötbad (2) bemessene Temperatur vorgeheizt ist und die Düse(n) (6) derart angeordnet ist (sind), daß lediglich die Lötseite der Schaltungsträger (4) direkt angeströmt wird.

2. Verfahren nach Anspruch 1, dadurch gekennzeichnet, daß die Vorheizung des Schutzgases derart gesteuert ist, daß das Schutzgas mit einer mehr als das Doppelte der gewünschten Temperatur der Lötseite der Schaltungsträger (4) bei deren Ankunft am Lötbad (2) betragenden Temperatur auf die Lötseite auftrifft und daß die Zufuhr des Schutzgases und/oder das Verweilen der Schaltungsträger vor der (den) Düse(n) (6) kurzzeitig erfolgt.

3. Verfahren nach Anspruch 1 oder 2, dadurch gekennzeichnet, daß die Schaltungsträger über derart angeordnete Düsen (6) angeströmt werden, daß sich eine annähernd gleichmäßige Temperaturverteilung auf der Lötseite der Schaltungsträger (4) einstellt.

4. Verfahren nach Anspruch 3, dadurch gekennzeichnet, daß Düsen (6) mit schlitzförmigen Austrittsöffnungen verwendet werden.

5. Verfahren nach Anspruch 3 oder 4, dadurch gekennzeichnet, daß die Schaltungsträger (4) über Düsen (6) angeströmt werden, die zumindest gruppenweise über stellbare Ventile (7) an eine Gasversorgung (8) angeschlossen sind.

## Claims

1. A method of soldering printed circuit boards (4) in an inert gas soldering device, in whose heatable reaction chamber, which is gas-tight with respect to its environment, there are arranged at least one soldering bath (2) and at least one nozzle (6) for the introduction of the inert gas positioned in front of the soldering bath (2), considered in the direction of passage of the circuits boards (4), characterised in that the inert gas is pre-heated to a temperature which is at least slightly higher than the desired temperature of the soldering side of the circuit boards (4) on their arrival af the soldering bath (2) ; and that the nozzle(s) (6) is (are) so arranged that only the soldering side of the circuit boards (4) is directly subjected to the flow.

2. A process as claimed in Claim 1, characterised in that the pre-heating of the inert gas is so controlled that the inert gas reaches the soldering side at a temperature which is more than double the desired temperature of the soldering side of the circuit boards (4) on their arrival at the soldering bath (2), and that the inert gas feed and/or the dwell time of the circuit boards in front of the nozzle(s) (6), is short.

3. A process as claimed in Claim 1 or 2, characterised in that the circuit boards are subjected to the inert gas flow through nozzles (6) so arranged that an approximately uniform temperature distribution is achieved at the soldering side of the circuit boards (4).

4. A process as claimed in Claim 3, characterised in that nozzles having slot-like outlet openings are used.

5. A process as claimed in claim 3 or 4, characterised in that the circuit boards (4) are subjected to the inert gas flow through nozzles (6) which are connected, at least in groups, through adjustable valves (7) to a gas supply (8).

## Revendications

1. Procédé pour braser des supports de circuits en forme de plaques (4) dans un appareil à braser sous atmosphère protectrice, possédant une enceinte de réaction pouvant être chauffée et qui est étanche au gaz vis-à-vis de l'environnement, dans laquelle sont disposés au moins un bain de brasage (2) et au moins une tuyère (6) pour introduire le gaz protecteur, située en amont du bain de brasage (2) dans le sens du passage des supports de circuits (4), caractérisé en ce que l'on préchauffe le gaz protecteur à une température ajustée au moins légèrement plus haute que la température désirée du côté brasage des supports de circuits (4) à leur arrivée au bain de brasage (2) et que l'on dispose la tuyère ou les tuyères (6) de manière que le gaz protecteur soit seulement dirigé directement sur le côté brasage des supports de circuits (4).

2. Procédé selon la revendication 1, caractérisé en ce que l'on règle le préchauffage du gaz protecteur de manière que ce gaz rencontre le côté brasage avec une température qui est plus du double de la température désirée de ce côté des supports de circuits (4) à leur arrivée au bain de brasage (2) et que l'amenée du gaz protecteur et/ou le séjour des supports de circuits avant la ou les tuyères (6) est court.

3. Procédé selon la revendication 1 ou 2, caractérisé en ce que l'on dirige le gaz protecteur sur les supports de circuits par des tuyères (6) disposées de manière qu'une distribution de température à peu près uniforme s'établisse sur le côté brasage des supports de circuits (4).

4. Procédé selon la revendication 3, caractérisé en ce que l'on utilise des tuyères (6) avec des orifices de sortie en forme de fentes.

5. Procédé selon la revendication 3 ou 4, caractérisé en ce que l'on dirige le gaz protecteur sur les supports de circuits (4) par des tuyères (6) qui sont raccordées, au moins par groupes, à une alimentation en gaz (8) à travers des soupapes (7) réglables.